# EUROPEAN PATENT APPLICATION

(11) **EP 2 851 714 A1**
(43) Date of publication of application: **25.03.2015**
(21) Application number: 13791132.7
(22) Date of filing: 17.05.2013
(51) Int. Cl.: G02B 1/11, B29C 39/10, B29C 59/02, B32B 7/02, G02B 5/22, H01L 31/04, B29L 9/00, B29L 11/00

(54) **FILM, METHOD FOR PRODUCING SAME, PLATE-LIKE PRODUCT, IMAGE DISPLAY DEVICE, AND SOLAR CELL**

(30) Priority: 18.05.2012 JP 2012114419
(71) Applicant: Mitsubishi Rayon Co., Ltd., Tokyo 100-8253 (JP)
(72) Inventor: ONOMOTO Hiroshi, Otake-shi Hiroshima 739-0693 (JP)
(74) Representative: Hoffmann Eitle
(86) International application number: PCT/JP2013/063779
(87) International publication number: WO 2013/172448

(57) **Abstract**

A film which is provided with a concave-convex microstructure body that has a concave-convex microstructure formed of a cured product of an active energy ray curable resin composition on a surface and an ultraviolet ray blocking layer that is adjacent to a surface of the concave-convex microstructure body, the surface being on the reverse side of the concave-convex microstructure-side surface, a method for producing the film, and a plate-like product, an image display device and a solar cell that are provided with the film.

## Description

### TECHNICAL FIELD

The present invention relates to a film, a method for producing the same, and a plate-like product, an image display device, and a solar cell that are provided with the film.

The present invention claims priority to Japanese Patent Application No. 2012-114419 which has been filed in Japan on May 18,2012, and the content of which is incorporated herein by reference.

### BACKGROUND ART

An interface (surface) in various displays, lenses, and show windows that are in contact with air has a problem of decreased recognizability due to reflection of sunlight, illumination light, or the like on a surface.

As a way of lowering the reflection, a method of laminating a film with several layers having different refractive index on a surface of a subject for adhesion is known to have cancellation of reflected light on a film surface and reflected light on an interface between a film and a subject for adhesion by interference. Such film is generally produced by a method such as sputtering, vapor deposition, or coating. However, according to such method, there is a limit in lowering the reflectivity and wavelength dependency of the reflectivity although the film lamination number is increased. Further, for reducing the lamination number to save the production cost, it is required to have a material with even lower refractive index.

For lowering the refractive index of a material, introducing air to the material according to a certain method is effective. As an example thereof, a method of forming a concave-convex microstructure on a film surface as shown in Fig. 4A is widely known (see, Patent Document 1). According to this method, since the refractive index of the entire layer on a surface of a film having a concave-convex microstructure formed on the surface (concave-convex microstructure body 10) is determined by the volume ratio between air and materials constituting the concave-convex microstructure, it is possible to dramatically lower the refractive index. Accordingly, the reflectivity can be lowered even with a small number of lamination.

As a method for forming a concave-convex microstructure on a film surface, the methods described below have been suggested, for example.
- A method for performing injection molding or press molding by using a mold which has a concave-convex microstructure formed on the surface (Method 1).
- A method which includes placing an active energy ray curable resin composition between a mold and a substrate, curing the active energy ray curable resin composition by irradiation of active energy ray to transfer a concave-convex microstructure of the mold onto a cured product, and peeling the mold from the cured product (Method 2).
- A method which includes transferring a concave-convex microstructure of a mold onto an active energy ray curable resin composition, peeling the mold from the active energy ray curable resin composition, and curing the active energy ray curable resin composition by irradiation of active energy ray (Method 3).

Among them, considering the transfer property of a concave-convex microstructure and the degree of freedom of surface composition, the method of transferring a concave-convex microstructure of a mold according to curing of a resin composition by irradiation of active energy ray (Methods 2 and 3) is preferable. This method is particularly preferable for a case in which a belt-like or a roll-like mold allowing continuous production is used, and it is a method with excellent productivity.

However, a subject for adhesion or an element present in an inner side of a subject for adhesion (for example, an object like drawing or an artifact present in a room, a deflection device, a pigment, and an electrolyte liquid) may fade, get discolored, or deteriorated by ultraviolet ray.

If the concave-convex microstructure body attached to a subject for adhesion has an ultraviolet ray blocking function (UV cutting property), not only the reflection can be prevented by adhesion on a subject for adhesion but also the subject for adhesion or an element present in its inner side can be simultaneously protected from ultraviolet ray.

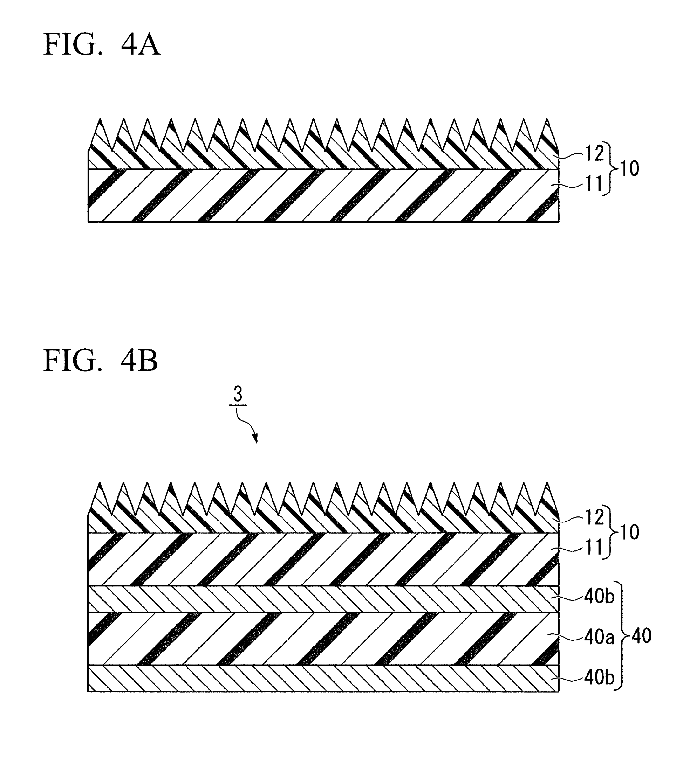

In order for the concave-convex microstructure body 10 shown in Fig. 4A to have an ultraviolet ray blocking function, a substrate 11 containing an ultraviolet ray absorbing agent can be used or a cured product 12 having a concave-convex microstructure on a surface thereof may be formed by curing an active energy ray curable resin composition which has been blended with an ultraviolet ray absorbing agent.

However, since an active energy ray curable resin composition is cured by irradiation of active energy ray such as ultraviolet ray, curing cannot be progressed sufficiently when an ultraviolet ray absorbing agent is blended in an active energy ray curable resin composition, and thus the concave-convex microstructure body 10 cannot be obtained. Further, since active energy ray is generally irradiated from the substrate 11 side for curing an active energy ray curable resin composition, curing cannot be progressed sufficiently even when the substrate 11 containing an ultraviolet ray absorbing agent is used.

For such reasons, in order for the concave-convex microstructure body 10 to have an ultraviolet ray blocking function, it is necessary to adhere, on a surface of the concave-convex microstructure body 10, the surface being on the reverse side of the concave-convex microstructure-side surface (hereinbelow, referred to as a "back surface"), an UV cut film 40 having an adhesive material layer 40b on both surfaces of a substrate 40a with an ultraviolet ray blocking function as shown in Fig. 4B.

### CITATION LIST

### PATENT DOCUMENT

Patent Document 1: WO 2008/096872 A

### DISCLOSURE OF THE INVENTION

### PROBLEM TO BE SOLVED BY THE INVENTION

However, as shown in Fig. 4B, a film 3 having the UV cut film 40 attached to the back surface of the concave-convex microstructure body 10, that is, the film 3 having, on the back surface of the concave-convex microstructure body 10, the substrate 40a with an ultraviolet ray blocking function via the adhesive material layer 40b, has a problem that the total film thickness is increased.

The present invention is achieved under the circumstances described above, and an object of the invention is to provide a thin film having an ultraviolet ray blocking function, a method for producing it, and a plate-like product, an image display device, and a solar cell that are provided with the film.

### MEANS FOR SOLVING PROBLEM

The present invention has characteristics that are described below.
<1> A film provided with a concave-convex microstructure body that has a concave-convex microstructure formed of a cured product of an active energy ray curable resin composition on a surface and an ultraviolet ray blocking layer that is adjacent to a surface of the concave-convex microstructure body, the surface being on the reverse side of the concave-convex microstructure-side surface.
<2> The film described in <1>, in which the peeling force of the ultraviolet ray blocking layer measured by the following method is more than 5 N/25 mm.

### (Method for measuring peeling force of ultraviolet ray blocking layer)

The film is placed on a surface of an acrylic resin plate such that the ultraviolet ray blocking layer is in contact with the acrylic resin layer, the film is attached to the acrylic resin plate by one reciprocal movement of a roll with a weight of 2 kg on top of the film, and after keeping it for 30 minutes at constant temperature of 23°C, the film is detached at a detachment rate of 0.3 m/min and an angle of 90° relative to the surface of the acrylic resin plate, and the peeling force required for the peeling is measured.
<3> The film described in <1>, in which the peeling force of the ultraviolet ray blocking layer measured by the following method is 0.1 to 5 N/25 mm.

### (Method for measuring peeling force of ultraviolet ray blocking layer)

The film is placed on a surface of an acrylic resin plate such that the ultraviolet ray blocking layer is in contact with the acrylic resin layer, the film is attached to the acrylic resin plate by one reciprocal movement of a roll with a weight of 2 kg on top of the film, and after keeping it for 30 minutes at constant temperature of 23°C, the film is detached at a detachment rate of 0.3 m/min and an angle of 90° relative to the surface of the acrylic resin plate, and the peeling force required for the peeling is measured.
<4> The film described in any one of <1> to <3>, in which the ultraviolet ray blocking layer contains a resin having (meth)acrylic acid ester as a polymerizable component.
<5> The film described in any one of <1> to <4>, in which transmittance is 55% or less.
<6> The film described in any one of <1> to <5>, in which the ultraviolet ray blocking layer has transmittance of 70% or less.
<7> The film described in any one of <1> to <6>, in which a protective layer is formed on a concave-convex microstructure-side surface of the concave-convex microstructure body.
<8> The film described in <7>, in which low-speed peeling force P of the protective layer that is measured by the following method in view of JIS Z 0237:2009 is equal to or more than 0.01 N/25 mm but less than 2.5 N/25 mm and the ratio between high-speed peeling force Q of the protective layer that is measured by the following method in view of JIS Z 0237:2009 and the low-speed peeling force P (high-speed peeling force Q/low-speed peeling force P) is less than 2.

### (Method for measuring low-speed peeling force P and high-speed peeling force Q of the protective layer)

The protective layer is placed on a surface of an acrylic resin plate such that the surface of the protective layer, which is in contact with the concave-convex microstructure-side surface, is in contact with the acrylic resin layer, the protective layer is attached to the acrylic resin plate by one reciprocal movement of a roll with a weight of 2 kg on top of the protective layer, and after keeping it for 30 minutes at constant temperature of 23°C, the protective layer is detached at a detachment rate of 0.3 m/min (for measurement of low-speed peeling force P) or 10 m/min (for measurement of high-speed peeling force Q) and an angle of 180° relative to the surface of the acrylic resin plate, and the peeling force required for the peeling is measured.
<9> A method for producing the film described in any one of <1> to <8>, in which a material for forming an ultraviolet ray blocking layer is coated on a surface of the concave-convex microstructure body that has a concave-convex microstructure formed of a cured product of an active energy ray curable resin composition on a surface, the surface being on the reverse side of the concave-convex microstructure-side surface, and the material is either dried or cured.
<10> A method for producing the film described in any one of <1> to <8>, in which an ultraviolet ray blocking layer having an adhesive property is formed on a surface of the concave-convex microstructure body that has a concave-convex microstructure formed of a cured product of an active energy ray curable resin composition on a surface, the surface being on the reverse side of the concave-convex microstructure-side surface.
<11> The method for producing a film described in <9> or <10>, in which a protective layer is formed on the concave-convex microstructure-side surface of the concave-convex microstructure body.
<12> A plate-like product provided with the film described in any one of <I> to <8>.
<13> An image display device provided with the film described in any one of <1> to <8>.
<14> A solar cell provided with the film described in any one of <1> to <8>.

### EFFECT OF THE INVENTION

According to the present invention, a thin film having an ultraviolet ray blocking function, a method for producing the film, and a plate-like product, an image display device and a solar cell that are provided with the film can be provided.

### BRIEF DESCRIPTION OF DRAWINGS

Fig. 1 is a cross-sectional view illustrating an example of the film of the present invention.
Fig. 2 is a cross-sectional view illustrating another example of the film of the present invention.
Fig. 3 is a cross-sectional view illustrating a use example of the film of the present invention.
Fig. 4A is a cross-sectional view illustrating an example of the concave-convex microstructure body and 4B is a cross-sectional view illustrating an example of a film of a related art.
Fig. 5 is a cross-sectional view illustrating the laminate obtained from Comparative Example 1.

### MODE(S) FOR CARRYING OUT THE INVENTION

Hereinbelow, the present invention is described in detail in view of the drawings.

Meanwhile, the "active energy ray" described herein indicates visible ray, ultraviolet ray, electron beam, plasma, heat ray (infrared ray or the like), or the like.

Further, the "ultraviolet ray" described herein indicates electromagnetic wave with a wavelength of 14 to 400 nm.

Further, the "wavelength of visible ray" described herein indicates a wavelength of 380 to 780 nm.

Further, the "ultraviolet ray blocking function (UV cutting property)" described herein indicates transmittance of 55% or less.

Further, the "transparent" described herein indicates transmitting at least the light with a wavelength of 400 to 1170 nm.

Further, the "(meth)acrylate" described herein is a general name for acrylate and methacrylate.

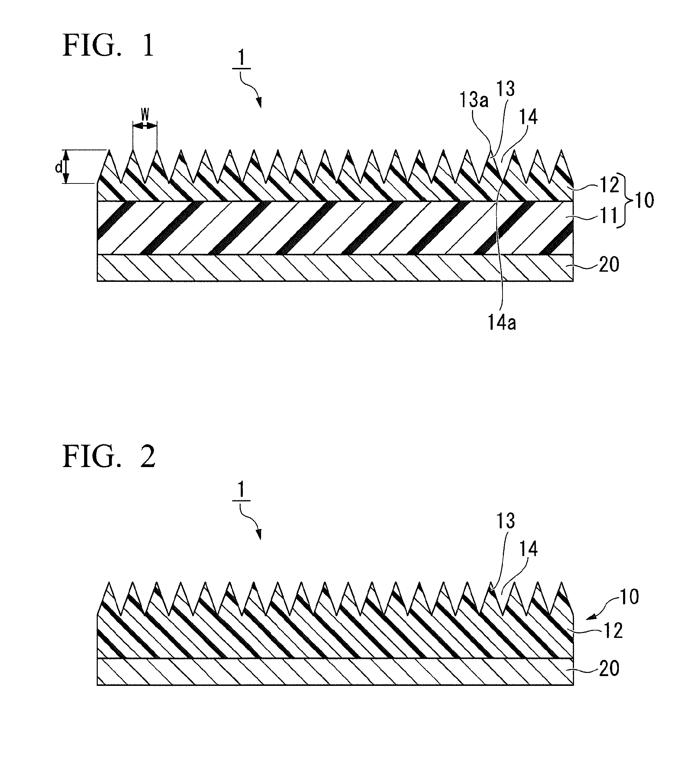

Further, in Figs. 1 to 5, the scale is different for each layer to have recognizable size of each layer in the drawing. Meanwhile, in Figs. 2 to 5, the same constitutional elements as those of Fig. 1 are given with the same symbol, and the explanations may be omitted.

### "Film"

Fig. 1 is a cross-sectional view illustrating an example of the film of the present invention.

A film 1 of this example is provided with a concave-convex microstructure body 10 that has a concave-convex microstructure formed of a cured product 12 of an active energy ray curable resin composition on a surface, and an ultraviolet ray blocking layer 20 that is adjacent to, or directly formed on a surface of the concave-convex microstructure body 10, which is the surface on the reverse side of the concave-convex microstructure-side surface.

Meanwhile, in the present invention, the concave-convex microstructure-side surface of the concave-convex microstructure body 10 is referred to as a "surface of the concave-convex microstructure body", and the surface on the reverse side of the concave-convex microstructure-side surface is referred to as a "back surface of the concave-convex microstructure body".

Transmittance of the film 1 is 55% or less. When the transmittance of the film 1 is 55% or less, a good ultraviolet ray blocking effect is obtained. The transmittance of the film 1 is preferably 30% or less.

### <Ultraviolet ray blocking layer>

The ultraviolet ray blocking layer 20 is a layer having an ultraviolet ray blocking function.

The ultraviolet ray blocking layer 20 is not particularly limited, if it has an ultraviolet ray blocking function. However, it is preferably transparent. Examples of a material for forming the ultraviolet ray blocking layer 20 include various adhesive materials containing an ultraviolet ray absorbing agent.

The ultraviolet ray blocking layer 20 preferably has an adhesive property. If the ultraviolet ray blocking layer has an adhesive property, the film 1 can be directly attached to a subject for adhesion. The adhesive property can be either hardly-peelable or easily-peelable (re-peelable), and it can be determined based on use of the film 1. Further, it is also possible that it is hardly-peelable in normal state but becomes easily-peelable upon receiving a stimulation from outside such as heat or light. A resin exhibiting an adhesive property (tackiness) at room temperature is preferable, in particular.

The adhesive force of the ultraviolet ray blocking layer 20 having an adhesive property can be obtained from the peeling force of the ultraviolet ray blocking layer 20, which is measured according to the following method. If the peeling force of the ultraviolet ray blocking layer 20 is more than 5 N/25 mm, strong adhesive force is yielded so that it is difficult for the film 1 to peel off from the subject for adhesion. The film 1 provided with the ultraviolet ray blocking layer 20 which has peeling force of more than 5 N/25 mm is preferred for use in an inner surface of an electronic display device, a door mirror of an automobile, or the like, for example.

Meanwhile, if the peeling force of the ultraviolet ray blocking layer 20 is 0.1 to 5 N/25 mm, it becomes easier to adhere or peel off the film 1 on a subject for adhesion. The film 1 provided with the ultraviolet ray blocking layer 20 which has peeling force of 0.1 to 5 N/25 mm is preferred for use on a surface of a cellular phone or the like, for example.

### (Method for measuring peeling force of ultraviolet ray blocking layer)

The film is placed on a surface of an acrylic resin plate such that the ultraviolet ray blocking layer is in contact with the acrylic resin layer, the film is attached to the acrylic resin plate by one reciprocal movement of a roll with a weight of 2 kg on top of the film, and after keeping it for 30 minutes at constant temperature of 23°C, the film is detached at a detachment rate of 0.3 m/min and an angle of 90° relative to the surface of the acrylic resin plate, and the peeling force required for the peeling is measured.

The peeling force of the ultraviolet ray blocking layer 20 can be adjusted by suitably modifying the type or amount of a cross-linking agent included in an adhesive material, the length or type of a polymer chain to be a skeleton, thickness of the ultraviolet ray blocking layer 20, or the like. It is also possible to adjust the adhesive force by controlling an adhesion area by forming irregularities on a surface of the ultraviolet ray blocking layer 20.

Examples of the material for the ultraviolet ray blocking layer 20 having an adhesive property include various adhesive materials such as rubber-based adhesive material, acrylic-based adhesive material, silicone-based adhesive material, or a urethane-based adhesive material that are blended with an ultraviolet ray absorbing agent. Among those described, the acrylic-based adhesive material is preferred as an adhesive material.

The adhesive material generally contains a resin with an adhesive property.

Examples of the resin with an adhesive property include a resin which has (meth)acrylic acid ester as a polymerizable component (hereinbelow, also referred to as "acrylic-based polymer"), and those having, as a main polymer, a copolymer of ethylene-vinyl acetate, linear type low density polyethylene, a copolymer of ethylene-α-olefin, a block copolymer of styrene-butadiene-styrene, a block copolymer of styreneisoprene-styrene, a block copolymer of styrene-ethylene-butylene-styrene, a random copolymer of styrene-butadiene, a hydrogenated random copolymer of styrene-butadiene, or the like.

As for the main polymer of an adhesive material, the acrylic-based polymer is preferred from the viewpoint of obtaining a balance between adhesive property and peeling property.

The acrylic-based polymer is obtained by homopolymerization or copolymerization of one or more types of a monomer having an alkyl group with 1 to 18 carbon atoms such as (meth)acrylate, and if necessary, one or more types of a monomer for modifying the copolymerization property by a known polymerization method such as liquid polymerization, emulsion polymerization, or photopolymerization. Further, narrowing the molecular weight distribution of the main polymer by a living radical polymerization or the like is effective for reducing sticky residues at the time of peeling the ultraviolet ray blocking layer 20 having an adhesive property.

Examples of the copolymerization component for forming an acrylic-based polymer include acids such as acrylic acid, methacrylic acid, or crotonic acid; (meth)acrylate containing carboxy group such as itaconic acid or maleic acid; (meth)acrylate containing hydroxyl group such as hydroxymethyl (meth)acrylate, 2-hydroxyethyl (meth)acrylate, or N-methylol acrylamide; alkyl (meth)acrylic acid ester having an alkyl group with 1 to 12 carbon atoms such as methyl (meth)acrylate, ethyl (meth)acrylate, butyl (meth)acrylate, n- or i-propyl (meth)acrylate, cyclohexyl (meth)acrylate, 2-ethylhexyl acrylate, n- or i-octyl (meth)acrylate, or lauryl (meth)acrylate; and a polymerizable vinyl-based monomer such as vinyl acetate, vinyl propionate, vinyl butyrate, styrene, or acrylonitrile.

Having a cross-linking agent contained in the resin with an adhesive property is also a preferred embodiment. Examples of the preferred cross-linking agent include an isocyanate-based cross-linking agent such as hexamethylene diisocyanate, tolylene diisocyanate, or polyisocyanate; a glycidyl-based cross linking agent such as ethylene glycol diglycidyl ether or propylene glycol diglycidyl ether; a polyfunctional aziridine-based cross-linking agent, a metal chelate-based cross-linking agent, and a peroxide-based cross-linking agent, and it is used either singly or in combination thereof. Further, amines, imidazoles, and carboxylic acids are also preferably used as they can promote the cross-linking.

The transmittance of the ultraviolet ray blocking layer 20 is preferably 70% or less. If the transmittance of the ultraviolet ray blocking layer 20 is 70% or less, transmittance of the film 1 having the concave-convex microstructure body 10 can easily have the transmittance of 55% or less, and thus a good ultraviolet ray blocking effect is obtained.

Further, it is preferable that the ultraviolet ray blocking layer 20 have little absorption of the wavelength in the visible light range. The smaller the wavelength in the visible light range is, the better appearance is obtained without deteriorating the color of a subject for adhesion when the film 1 is attached to a subject for adhesion.

Further, with regard to the ultraviolet ray blocking layer 20, it is preferable to have a small difference in refractive index compared to the concave-convex microstructure body 10 (in the case of the film 1 shown in Fig. 1, the difference in refractive index between the ultraviolet ray blocking layer 20 and the substrate 11 of the concave-convex microstructure body 10 which is described below). Specifically, the difference in refractive index is preferably 0.3 or less. It is more preferably 0.1 or less. As the difference in refractive index becomes decreases, light reflection on an interface between the ultraviolet ray blocking layer 20 and the concave-convex microstructure body 10 also decreases, and thus the film 1 with even lower reflectivity can be obtained.

Thickness of the ultraviolet ray blocking layer 20 is preferably 1 to 100 µm, and more preferably 5 to 30 µm. When the thickness of the ultraviolet ray blocking layer 20 is 1 µm or more, the ultraviolet ray blocking layer 20 can be formed without thickness unevenness. Meanwhile, when the ultraviolet ray blocking layer 20 is 100 µm or less, an increase in overall thickness of the film 1 can be suppressed, and therefore the film 1 can be used for an area which has thickness limitation.

### <Concave-convex microstructure body>

The concave-convex microstructure body 10 shown in Fig. 1 has the cured product 12 of an active energy ray curable resin composition formed on top of the substrate 11 and, on a surface of the cured product 12, a concave-convex microstructure for exhibiting an anti-reflection activity is formed.

### (Substrate)

It is sufficient that the material of the substrate 11 is light-transmitting, and examples thereof include a resin such as methyl methacrylate (co)polymer, polycarbonate, styrene (co)polymer, methyl methacrylate-styrene copolymer, cellulose diacetate, cellulose triacetate, cellulose acetate butyrate, polyester, polyamide, polyimide, polyether sulfone, polysulfone, polypropylene, polymethylpentene, polyvinyl chloride, polyvinyl acetal, polyether ketone, or polyurethane, and glass.

Shape of the substrate 11 is preferably sheet-like or film-like.

Examples of the method for producing the substrate 11 include injection molding, extrusion molding, and cast molding.

The surface of the substrate 11 can be treated with a coating or a corona treatment for the purpose of improving adhesiveness, an anti-static property, scratch resistance, weather resistance, or the like.

### (Cured product)

The cured product 12 is a cured product of an active energy ray curable resin composition and it has a concave-convex microstructure on the surface.

The concave-convex microstructure of this example is formed of a convex part 13 and a concave part 14 which have a conical shape and are arranged at a constant interval.

For exhibition of a good anti-reflection activity, the average interval between two neighboring convex parts 13 (or the concave part 14) of a concave-convex microstructure preferably has a size which is smaller than the wavelength of visible light. When the average interval between two neighboring convex parts 13 is 380 nm or less, scattering of visible light can be sufficiently suppressed.

As described herein, the average interval between neighboring convex parts is obtained by observing the surface of the concave-convex microstructure body 10 with an electron microscope, measuring the distance w between the center (top portion) 13a of any convex part 13 and the center 13a of the convex part 13 adjacent thereto at 10 points, and averaging the values obtained therefrom.

Further, the average height of the convex part 13 (or the average depth of the concave part 14) is preferably 60 nm or more, and more preferably 90 nm or more. When the average height of the convex part 13 is 60 nm or more, an increase in minimum reflectivity or reflectivity at specific wavelength can be suppressed, and thus a sufficient anti-reflection activity is obtained.

As described herein, the average height of the convex part 13 is obtained by observing the surface of the concave-convex microstructure body 10 with an electron microscope, measuring the vertical distance d between the center (bottom portion) 14a of the concave part 14 and the center (top portion) 13a of the convex part 13 at 10 points, and obtaining the average value therefrom.

Further, although the shape of the convex part 13 of a concave-convex microstructure is not particularly limited, for obtaining an anti-reflection activity which enables both the low reflectivity and low wavelength dependency by continuously increasing the refractive index from air to the surface of a material for forming a concave-convex microstructure, preferred is an approximately conical shape as shown in Fig. 1, a pyramidal shape, or a temple bell shape in which the area occupancy ratio, which is obtained by having a cut on the film surface, increases continuously from the center (top portion) 13a of the convex part 13 to the substrate 11 side. In addition, it is also possible that a number of even finer concave parts are integrated to form the concave-convex microstructure described above.

### <Method for film production>

The film of the present invention is obtained by directly forming an ultraviolet ray blocking layer on a back surface of the concave-convex microstructure body described above.

As for the concave-convex microstructure body, a commercially available product may be used or those produced as described below may be used.

### (Production of concave-convex microstructure body)

The method for producing a concave-convex microstructure body is not particularly limited, and the examples thereof include a method for performing injection molding or press molding by using a mold having a reversed structure of a concave-convex microstructure formed on the surface (Method 1), a method which includes using a roll-like mold, placing an active energy ray curable resin composition between the mold and a substrate, curing the active energy ray curable resin composition by irradiation of active energy ray to transfer a concave-convex microstructure of the mold, and peeling the mold (Method 2), and a method which includes transferring a concave-convex microstructure of a mold onto an active energy ray curable resin composition, peeling the mold, and curing the active energy ray curable resin composition by irradiation of active energy ray (Method 3). Among them, considering the transfer property of a concave-convex microstructure and the degree of freedom of surface composition, Methods 2 and 3 are preferable. Method 2 is particularly preferable.

As a method for forming a reversed structure of a concave-convex microstructure on a mold, an electron beam lithography method, a laser beam interference method, or the like can be mentioned. For example, by coating a suitable photoresist film on a surface of a suitable supporting substrate and performing exposure with light such as ultraviolet laser, electron beam, or X ray, followed by development, a mold having a concave-convex microstructure formed thereon can be obtained. It is also possible to directly form a concave-convex microstructure on a supporting substrate itself by selectively etching the supporting substrate by dry etching as mediated by a photoresist layer followed by removal of the resist layer.

It is also possible to use an anodic oxidized porous alumina as a mold. For example, a 20 to 200 nm porous structure which is formed by anodic oxidation of aluminum at pre-determined voltage by using oxalic acid, sulfuric acid, phosphoric acid, or the like as an electrolyte solution can be also used as a mold. According to this method, since the oxidized film is first removed after highly pure aluminum is subjected to anodic oxidation at constant voltage for a long period of time and subjected again to the anodic oxidation, pores with very high regularity can be formed in a self-organizing manner. Further, since the anodic oxidation treatment and pore enlarging treatment are combined during the process of the second anodic oxidation, it becomes possible to form pores of which cross-section has a triangle or temple bell shape instead of a rectangular shape. Further, by suitably adjusting the time or conditions for the anodic oxidation treatment and pore enlarging treatment, the innermost angle of the pore can be also sharpened.

Further, a copy mold can be produced by electroforming or the like from a mother mold having a concave-convex microstructure.

Shape of the mold itself is not particularly limited, and it can be any one of a plate-like, a belt-like, and a roll-like. When it is a belt-like or a roll-like, in particular, continuous transfer of a concave-convex microstructure can be achieved, and thus the productivity can be further enhanced.

As a method of adding an active energy ray curable resin composition between a mold and a substrate, a method of pressurizing a mold and a substrate after adding an active energy ray curable resin composition between the mold and the substrate so as to inject an active energy ray curable resin composition to a concave-convex microstructure of the mold can be mentioned.

The active energy ray curable resin composition is a resin composition which is cured according to progress of a polymerization reaction caused by irradiation of active energy ray.

The active energy ray curable resin composition contains a polymerization-reactive monomer component, an active energy ray polymerization initiator, and if necessary, other components.

With regard to the polymerization-reactive monomer component or active energy ray polymerization initiator that are suitable for forming a concave-convex microstructure, a known component can be applied. Examples of the polymerization-reactive monomer component include a monomer, an oligomer, and a reactive polymer having a radical polymerizable bond and/or cation polymerizable bond in the molecule.

Examples of the monomer having a radical polymerizable bond include a monofunctional monomer and a polylfunctional monomer. Specific examples thereof include various (meth)acrylates and derivatives thereof.

Examples of the monomer having a cation polymerizable bond include a monomer having an epoxy group, an oxetanyl group, an oxazolyl group, a vinyloxy group, or the like.

As for the polymerization-reactive monomer component or active energy ray polymerization initiator that are suitable for forming a concave-convex microstructure, various compounds described in JP 2009-31764 A can be used, for example.

The active energy ray curable resin composition may contain, if necessary, additives such as an anti-oxidant, a releasing agent, a lubricating agent, a plasticizer, an anti-static agent, a photostabilizer, a flame retardant, a flame retardant aid, a polymerization inhibitor, a filling agent, a silane coupling agent, a coloring agent, an enforcing agent, an inorganic filler, and impact-resistant modifier.

Further, when the concave-convex microstructure body consists of the substrate 11 and the cured product 12 shown in Fig. 1, it is preferable that the active energy ray curable resin composition have a small difference in refractive index compared to the substrate 11 when it is cured. Specifically, the difference in refractive index between the cured product 12 of an active energy ray curable resin composition and the substrate 11 is preferably 0.3 or less, and more preferably 0.1 or less. As the difference in refractive index decreases, less light reflection on an interface between the cured product 12 and the substrate 11 is obtained, and thus the film I with even lower reflectivity can be obtained.

### (Forming of ultraviolet ray blocking layer)

As a method for directly forming (a method for adjoining) an ultraviolet ray blocking layer on a back surface of a concave-convex microstructure body, there is a method for forming an ultraviolet ray blocking layer by coating a material for forming an ultraviolet ray blocking layer on a back surface of a concave-convex microstructure body and drying or curing the material to form an ultraviolet ray blocking layer (Method 4) and a method for forming an ultraviolet ray blocking layer on a back surface of a concave-convex microstructure body by forming in advance an ultraviolet ray blocking layer with an adhesive property (Method 5).

According to Method 5, a material for forming an ultraviolet ray blocking layer with an adhesive property is coated on top of a film with peeling property (separator film), the material is dried or cured to form an ultraviolet ray blocking layer, the separator film is laminated on an exposed surface of the ultraviolet ray blocking layer, and use can be made after peeling the separator film when the ultraviolet ray blocking layer is attached to a back surface of the concave-convex microstructure body. It is also possible to use a commercially available sheet-like or film-like UV cut adhesive material and adhere it on a back surface of a concave-convex microstructure body so as to form an ultraviolet ray blocking layer consisting of an UV cut adhesive material.

Further, when the ultraviolet ray blocking layer has an adhesive property, a protective film may be additionally attached to an exposed surface of the ultraviolet ray blocking layer.

### <Working effect>

The film of the present invention as described above is provided with a concave-convex microstructure body that has a concave-convex microstructure on a surface and an ultraviolet ray blocking layer, and thus it has both the anti-reflection function and ultraviolet ray blocking function. As such, according to adhesion of the film of the present invention on a subject for adhesion, not only the reflection can be prevented but also the subject for adhesion or an element present in its inner side can be simultaneously protected from ultraviolet ray. In particular, if the ultraviolet ray blocking layer has an adhesive property, the film can be directly attached to a subject for adhesion. Further, the ultraviolet ray blocking layer with an adhesive property itself can be protected from deterioration caused by ultraviolet ray, and therefore it becomes possible to maintain the adhesive property at good level for a long period of time.

Further, according to the film of the present invention, the ultraviolet ray blocking layer is adjacent to a back surface of the concave-convex microstructure body (that is, the ultraviolet ray blocking layer is directly formed on a back surface of a concave-convex microstructure body). As such, unlike the film 3 of a related art in which the substrate 40a having an ultraviolet ray blocking function is formed on the back surface of the concave-convex microstructure body 10 via the adhesive material layer 40b as shown in Fig. 4B, the overall film thickness can be reduced.

### <Other embodiments>

The film of the present invention is not limited to the one shown in Fig. 1. The film 1 shown in Fig. 1 has a concave-convex microstructure formed on the entire surface the concave-convex microstructure body 10. However, the concave-convex microstructure may be formed on a part of a surface of a concave-convex microstructure body.

Further, as shown in Fig. 2, the concave-convex microstructure body 10 may not be provided with the substrate 11 and it may consist only of the cured product 12 of an active energy ray curable resin composition.

Further, a protective layer (protective film) may be formed on a surface of the concave-convex microstructure body, if necessary. By forming a protective layer, disruption of the shape or contamination of a convex part on a surface of the concave-convex microstructure body can be prevented.

The adhesive force between the protective layer and concave-convex microstructure body is preferably such that it does not allow easy peeling and yields a low level of sticky residues on the concave-convex microstructure after peeling. Specifically, it is such that the low-speed peeling force P of the protective layer that is measured by the following method in view of JIS Z 0237:2009 is equal to or more than 0.01 N/25 mm but less than 2.5 N/25 mm and the ratio between high-speed peeling force Q of the protective layer that is measured by the following method in view of JIS Z 0237:2009 and the low-speed peeling force P (high-speed peeling force Q/low-speed peeling force P) is less than 2.

### (Method for measuring low-speed peeling force P and high-speed peeling force Q of protective layer)

The protective layer is placed on a surface of an acrylic resin plate such that the surface of the protective layer in contact with the concave-convex microstructure-side surface is in contact with the acrylic resin layer, the protective layer is attached to the acrylic resin plate by one reciprocal movement of a roll with a weight of 2 kg on top of the protective layer, and after keeping it for 30 minutes at constant temperature of 23°C, the protective layer is detached at a detachment rate of 0.3 m/min (for measurement of low-speed peeling force P) or 10 m/min (for measurement of high-speed peeling force Q) and an angle of 180° relative to the surface of the acrylic resin plate, and the peeling force required for peeling is measured.

When the protective layer is formed on a surface of the concave-convex microstructure body, the timing for forming the protective layer is not particularly limited. It can be either before or after forming an ultraviolet ray blocking layer on a back surface of the concave-convex microstructure body.

### <Use>

The film of the present invention is preferred as an anti-reflection film.

The film of the present invention is used after being arranged on a surface of a plate-like product (for example, a cover of instruments, a front plate of a lighting device, a front plate of a frame, a case for painting, a showcase, glasses, and a window), an image display device (for example, a liquid crystal display device, a plasma display panel, an electroluminescence display, and a cathode tube display device), or a member for constituting a solar cell or the like (subject) such that the surface of the concave-convex microstructure body becomes the light incident side.

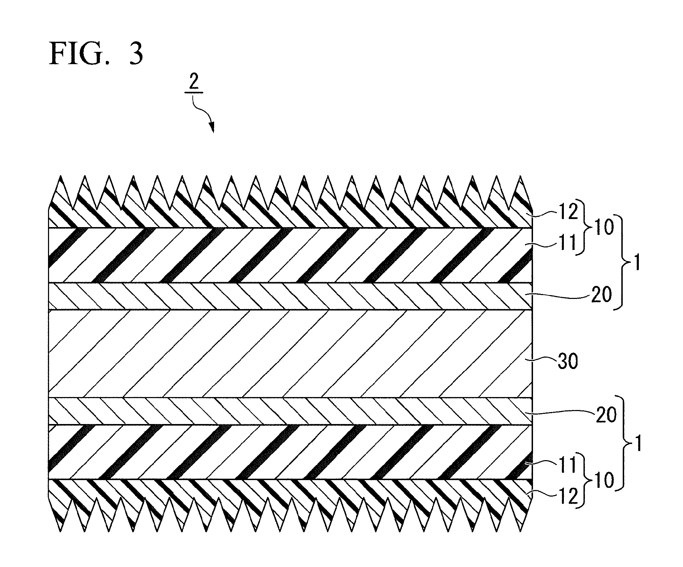

Further, as shown in Fig. 3 for example, it is also possible that the film 1 is attached to both surfaces of a transparent substrate 30 formed of a resin or a glass such that the surface of the concave-convex microstructure body 10 faces the outside (that is, light incident side) to give a laminate 2 and the laminate 2 is placed on a surface of a plate-like product, an image display device, or a member for constituting a solar cell or the like.

### EXAMPLES

Hereinbelow, the present invention is specifically described in view of the examples, but the present invention is not limited to them.

"Methods for various measurements and evaluations"
(1) Measurement of mold pore:
   On part of a longitudinal cross-section of a mold which consists of an anodic oxidized porous alumina, platinum was vapor-deposited for 1 minute and an observation was made at acceleration voltage of 3.00 kV by using a field emission scanning electron microscope (trade name: "JSM-7400F", manufactured by JEOL Ltd.) and the interval (period) between neighboring pores and depth of the pore were measured. Specifically, the measurement was made for 10 points for each of them, and the average value was taken as measured value.
(2) Measurement of convex part of concave-convex microstructure body:
   On a longitudinal cross section of a concave-convex microstructure body, platinum was vapor-deposited for 10 minutes and the interval (period) between neighboring convex parts and height of a convex part were measured by using the same apparatus and conditions as (1) above. Specifically, the measurement was made for 10 points for each of them, and the average value was taken as measured value.
(3) Measurement of reflectivity:
   Based on JIS Z 8722:2009, reflectivity was measured at incident angle of 8° by using an integrating ball and an UV spectrophotometer (trade name: "UV-2450", manufactured by Shimadzu Corporation).
(4) Measurement of transmittance:
   Based on JIS Z 8722:2009, transmittance was measured at a wavelength of 400 nm by using an integrating ball and an UV spectrophotometer (trade name: "UV-2450", manufactured by Shimadzu Corporation).
(5) Measurement of thickness:
   The total thickness of a laminate was measured by using a micrometer (trade name: "207-211 ", manufactured by Mitutoyo Corporation).
(6) Measurement of peeling force of ultraviolet ray blocking layer

A film was placed on a surface of an acrylic resin plate such that an ultraviolet ray blocking layer is in contact with the acrylic resin layer. The film was attached to the acrylic resin plate by one reciprocal movement of a roll with a weight of 2 kg on top of the film, and after keeping it for 30 minutes at constant temperature of 23°C, the film was detached at a detachment rate of 0.3 m/min and an angle of 90° relative to the surface of the acrylic resin plate, and the peeling force required for peeling was measured.

### "Production of mold"

An aluminum plate with purity of 99.99% was subjected to fabric polishing, and subsequently subjected to electrolytic polishing in a mixture solution of perchloric acid/ethanol (volume ratio of 1/4) to have mirror finish. Subsequently, the step (a) to the step (f) were performed.

### Step (a):

An aluminum plate with mirror finish was subjected to anodic oxidation in 0.3 M aqueous solution of oxalic acid for 30 minutes under the conditions including direct current of 40 V and temperature of 16°C to generate pores in an oxidized coating film.

### Step (b):

An aluminum plate having an oxidized coating film formed thereon was impregnated in a mixture solution of 6% by mass of phosphoric acid/1.8% by mass of chromic acid for 6 hours to remove the oxidized coating film and to expose periodic dents which correspond to the pores.

### Step (c):

An aluminum plate with exposed dents was subjected to anodic oxidation in 0.3 M aqueous solution of oxalic acid for 30 seconds under conditions including direct current of 40 V and temperature of 16°C to form an oxidized coating film having pores.

### Step (d):

An aluminum plate with oxidized coating film thereon was impregnated in 5% by mass of phosphoric acid at 32°C for 8 minutes to perform a treatment of enlarging the pore diameter.

### Step (e):

An aluminum plate obtained after the treatment of enlarging the pore diameter was subjected to anodic oxidation in 0.3 M aqueous solution of oxalic acid for 30 seconds under the conditions including direct current of 40 V and temperature of 16°C to form pores with small diameter which extend downward from the pores.

### Step (f):

The step (d) and the step (e) were repeated four times in total followed by the step (d) as a last step to obtain a mold which has anodic oxidized porous alumina formed on the surface, in which the alumina has approximately conical pores having average interval (period) of 100 nm and depth of 180 nm.

The obtained anodic oxidized porous alumina was washed with de-ionized water and moisture on the surface was removed using an air blower. It was then impregnated for 10 minutes in a solution in which a surface anti-fouling coating agent (trade name: "OPTOOL DSX", manufactured by Daikin Industries, Ltd.) is diluted with a diluent (trade name: "HD-ZV", manufactured by Harves Co., Ltd.) to have solid content of 0.1% by mass. After that, it was pulled out from the solution and dried by air for 20 hours to obtain a mold having a surface treated with a releasing agent.

### "Production of active energy ray curable resin composition"

20 parts by mass of dipentaerythritol penta(hexa)acrylate, 20 parts by mass of pentaerythritol tri(tetra)acrylate, 40 parts by mass of polyethylene glycol diacrylate, and 20 parts by mass of dimethyl acrylamide were admixed with one another and, 1 part by mass of "IRGACURE 184" and 0.5 part by mass of "IRGACURE 819" manufactured by BASF as a photostabilizer, and 0.1 part by mass of "TDP-2" manufactured by Nikko Chemicals Co., Ltd. as an internal releasing agent were further added and mixed to prepare an active energy ray curable resin composition.

Meanwhile, "dipentaerythritol penta(hexa) acrylate" means a mixture of dipentaerythritol pentaacrylate and dipentaerythritol hexaacrylate and "pentaerythritol tri(tetra)acrylate" means a mixture of pentaerythritol triacrylate and pentaerythritol tetraacrylate.

### "Example 1"

### <Production of concave-convex microstructure body>

Onto a surface of a mold having pores formed thereon, an active energy ray curable resin composition was poured and a triacetyl cellulose (TAC) film having thickness of 40 µm was spread and coated as a substrate on top of it. After that, by using a fusion UV illuminator, ultraviolet ray was irradiated at energy of 1000 mJ/cm² from the film side to cure the active energy ray curable resin composition. Subsequently, the mold was peeled off from the film to obtain a concave-convex microstructure body.

It was found that the concave-convex microstructure of the mold is transferred on the surface of the obtained concave-convex microstructure body, and a concave-convex microstructure with an approximately conical shape, which has average interval (period) w of 100 nm between two neighboring convex parts 13 and the average height d of 180 nm of the convex part 13, is formed as shown in Fig. 1.

### <Forming ultraviolet ray blocking layer>

A separator film on one side of a sheet-like UV cut adhesive material (trade name: "TD06UV0145", manufactured by Tomoegawa Co., Ltd., thickness of 25 µm and transmittance of 47%), which has a separator film formed on both surfaces, was peeled and attached to one surface of a transparent acrylic plate (trade name: "L001", manufactured by Mitsubishi Rayon Co., Ltd., thickness of 2 mm). Subsequently, the separator film on the other side of the UV cut adhesive material was peeled and attached to a back surface of a concave-convex microstructure body, and as shown in Fig. 3, the film 1 having the ultraviolet ray blocking layer 20, which consists of an UV cut adhesive material, adjacent to (formed directly on) a back surface of the concave-convex microstructure body 10 was laminated on one surface of the substrate 30 consisting of a transparent acrylic plate.

In the same manner as above, the film 1 having the ultraviolet ray blocking layer 20, which consists of an UV cut adhesive material, adjacent to (formed directly on) a back surface of the concave-convex microstructure body 10 was laminated on the other surface of the transparent acrylic plate, and thus the laminate 2 in which the film 1 is attached to both surfaces of the substrate 30 consisting of a transparent acrylic plate such that the surface of the concave-convex microstructure body 10 becomes an external side (light incident side) is obtained.

As a result of measuring the reflectivity, transmittance, and thickness of the obtained laminate, it was found that the reflectivity is 0.2%, transmittance is 26%, and thickness is 2.13 mm. Further, the peeling force of the ultraviolet ray blocking layer of the obtained laminate was found to be 7.4 N/25 mm.

### "Example 2"

A laminate was obtained in the same manner as Example 1 except that a slide glass with thickness of 1.2 mm (reflectivity of 8% and transmittance of 90%) is used instead of a transparent acrylic plate (trade name: "L001", manufactured by Mitsubishi Rayon Co., Ltd., thickness of 2 mm).

As a result of measuring the reflectivity, transmittance, and thickness of the obtained laminate, it was found that the reflectivity is 0.2%, transmittance is 26%, and thickness is 1.33 mm.

Further, two pieces of the laminate obtained from Example 2 were stacked on each other to form a spacer having width of 5 mm. Further, by fixing the cross section with an adhesive tape, double-layer glass was produced.

The obtained double-layer glass exhibited good appearance.

Further, the reflectivity was 0.4% and transmittance is 21% in a state in which two laminates are stacked on each other.

### "Example 3"

A separator film on one side of a sheet-like UV cut adhesive material (trade name: "MHM-FWD25UV", manufactured by Nichieikako Co., Ltd., thickness of 25 µm and transmittance of 54%), which has a separator film formed on both surfaces, was peeled and attached to one surface of a transparent acrylic plate (trade name: "L001", manufactured by Mitsubishi Rayon Co., Ltd., thickness of 2 mm). Subsequently, the separator film on the other side of the UV cut adhesive material was peeled and attached to a back surface of a concave-convex microstructure body, and as shown in Fig. 1, a laminate in which the film 1 having the ultraviolet ray blocking layer 20, which consists of an UV cut adhesive material, adjacent to (formed directly on) a back surface of the concave-convex microstructure body 10 was laminated on one surface of the substrate consisting of a transparent acrylic plate was obtained.

As a result of measuring the reflectivity, transmittance, and thickness of the obtained laminate, it was found that the reflectivity is 4.1 %, transmittance is 54%, and thickness is 2.07 mm. Further, the peeling force of the ultraviolet ray blocking layer of the obtained laminate was found to be 7.4 N/25 mm.

### "Comparative Example 1"

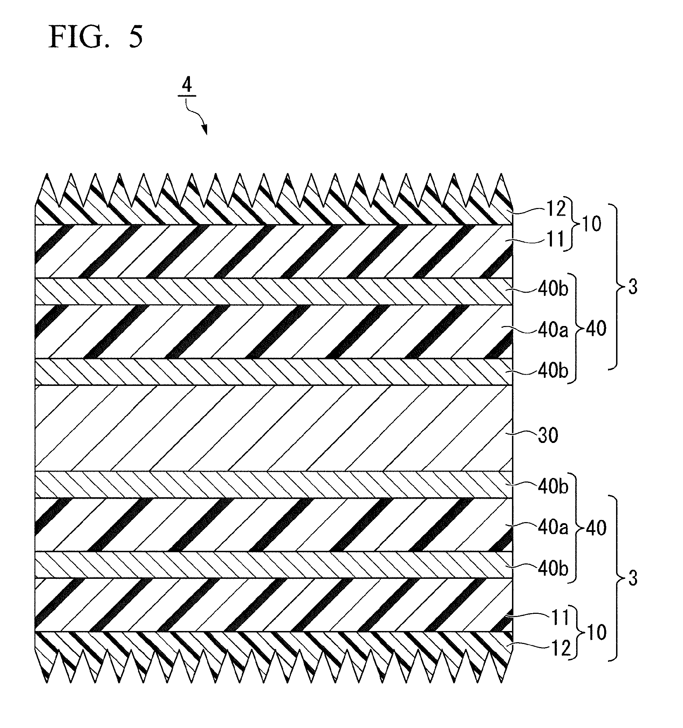

On an adhesive material of an UV cut film having an adhesive material layer formed on one surface of a substrate with an UV ray blocking function (trade name: "Scotchtint Nano 80S", manufactured by Sumitomo 3M Ltd., overall thickness of 76 µm), one surface of a transparent acrylic plate (trade name: "L001", manufactured by Mitsubishi Rayon Co., Ltd., thickness of 2 mm) was attached. Subsequently, a separator film on one side of a sheet-like adhesive material, which has a separator film formed on both surfaces, was peeled and attached to the other surface of the ultraviolet cut film. Subsequently, the separator film on the other side of the adhesive material was peeled and attached to a back surface of a concave-convex microstructure body, and as shown in Fig. 5, the film 3 having the substrate 40a with an ultraviolet ray blocking function which has been formed, via the adhesive material layer 40b, on a back surface of the concave-convex microstructure body 10 was laminated on one surface of the substrate 30 consisting of a transparent acrylic plate.

In the same manner as above, the film 3 in which the substrate 40a having an ultraviolet ray blocking function has been formed via the adhesive material layer 40b on a back surface of the concave-convex microstructure body 10 was laminated on the other surface of the transparent acrylic plate, and thus the laminate 4 in which the film 3 is attached to both surfaces of the substrate 30 consisting of a transparent acrylic plate such that the surface of the concave-convex microstructure body 10 becomes an external side (light incident side) is obtained.

As a result of measuring the reflectivity, transmittance, and thickness of the obtained laminate, it was found that the reflectivity is 0.2% and transmittance is 30%, and thus it has almost the same anti-reflection function and ultraviolet ray blocking function as those of the laminate obtained from Examples 1 and 2. However, the laminate obtained from Comparative Example 1 has thickness of 2.28 mm and it is thicker than the laminate obtained from Examples 1 and 2.

### "Comparative Example 2"

A laminate was obtained in the same manner as Example 3 except that an adhesive material having no UV cutting property (trade name: "OPTERIA MO-3006C", manufactured by Lintec Corporation, thickness of 25 µm) is used instead of a sheet-like UV cut adhesive material (trade name: "MHM-FWD25UV", manufactured by Nichieikako Co., Ltd., thickness of 25 µm and transmittance of 54%), which has a separator film formed on both surfaces.

As a result of measuring the reflectivity, transmittance, and thickness of the obtained laminate, it was found that the reflectivity is 4.1 %, transmittance is 70%, and thickness is 2.07 mm. Although the anti-reflection function was good, the ultraviolet ray blocking function was poor. Further, the peeling force of the ultraviolet ray blocking layer of the obtained laminate was found to be 15 N/25 mm.

### "Comparative Example 3"

It has been tried to produce a concave-convex microstructure body in the same manner as Example 1 by using 100 parts by mass of the active energy ray curable resin composition used in Example 1 further added with 5 parts by mass of an ultraviolet ray absorbing agent (trade name: "TINUVIN 400", manufactured by BASF Japan Ltd.). However, as the sufficient curing cannot be achieved, it was impossible to produce a concave-convex microstructure body.

### INDUSTRIAL APPLICABILITY

The film of the present invention is thin and has an ultraviolet ray blocking function.

### EXPLANATIONS OF LETTERS OR NUMERALS

- 1: Film
- 2: Laminate
- 3: Film
- 4: Laminate
- 10: Concave-convex microstructure body
- 11: Substrate
- 12: Cured product
- 13: Convex part
- 13a: Center (top portion of convex part)
- 14: Concave part
- 14a: Center (bottom portion of concave part)
- 20: Ultraviolet ray blocking layer
- 30: Substrate
- 40: UV cut film
- 40a: Substrate with ultraviolet ray blocking function
- 40b: Adhesive material layer

## Claims

1. A film provided with a concave-convex microstructure body that has a concave-convex microstructure formed of a cured product of an active energy ray curable resin composition on a surface and an ultraviolet ray blocking layer that is adjacent to a surface of the concave-convex microstructure body, the surface being on the reverse side of the concave-convex microstructure-side surface.

2. The film according to claim 1, wherein the peeling force of the ultraviolet ray blocking layer measured by the following method is more than 5 N/25 mm.
(Method for measuring peeling force of ultraviolet ray blocking layer)
The film is placed on a surface of an acrylic resin plate such that the ultraviolet ray blocking layer is in contact with the acrylic resin layer, the film is attached to the acrylic resin plate by one reciprocal movement of a roll with a weight of 2 kg on top of the film, and after keeping it for 30 minutes at constant temperature of 23°C, the film is detached at a detachment rate of 0.3 m/min and an angle of 90° relative to the surface of the acrylic resin plate, and the peeling force required for the peeling is measured.

3. The film according to claim 1, wherein the peeling force of the ultraviolet ray blocking layer measured by the following method is 0.1 to 5 N/25 mm.
(Method for measuring peeling force of ultraviolet ray blocking layer) The film is placed on a surface of an acrylic resin plate such that the ultraviolet ray blocking layer is in contact with the acrylic resin layer, the film is attached to the acrylic resin plate by one reciprocal movement of a roll with a weight of 2 kg on top of the film, and after keeping it for 30 minutes at constant temperature of 23°C, the film is detached at a detachment rate of 0.3 m/min and an angle of 90° relative to the surface of the acrylic resin plate, and the peeling force required for the peeling is measured.

4. The film according to claim 1, wherein the ultraviolet ray blocking layer contains a resin having (meth)acrylic acid ester as a polymerizable component.

5. The film according to claim 1, wherein transmittance is 55% or less.

6. The film according to claim 1, wherein the ultraviolet ray blocking layer has transmittance of 70% or less.

7. The film according to claim 1, wherein a protective layer is formed on a concave-convex microstructure-side surface of the concave-convex microstructure body.

8. The film according to claim 7, wherein low-speed peeling force P of the protective layer that is measured by the following method in view of JIS Z 0237:2009 is equal to or more than 0.01 N/25 mm but less than 2.5 N/25 mm and the ratio between high-speed peeling force Q of the protective layer that is measured by the following method in view of JIS Z 0237:2009 and the low-speed peeling force P (i.e., high-speed peeling force Q/low-speed peeling force P) is less than 2.
(Method for measuring low-speed peeling force P and high-speed peeling force Q of the protective film)
The protective layer is placed on a surface of an acrylic resin plate such that the surface of the protective layer, which is in contact with the concave-convex microstructure-side surface, is in contact with the acrylic resin layer, the protective layer is attached to the acrylic resin plate by one reciprocal movement of a roll with a weight of 2 kg on top of the protective layer, and after keeping it for 30 minutes at constant temperature of 23°C, the protective layer is detached at a detachment rate of 0.3 m/min (for measurement of low-speed peeling force P) or 10 m/min (for measurement of high-speed peeling force Q) and an angle of 180° relative to the surface of the acrylic resin plate, and the peeling force required for the peeling is measured.

9. A method for producing the film according to claim 1, wherein a material for forming an ultraviolet ray blocking layer is coated on a surface of the concave-convex microstructure body that has a concave-convex microstructure formed of a cured product of an active energy ray curable resin composition on a surface, the surface being on the reverse side of the concave-convex microstructure-side surface, and the material is either dried or cured.

10. A method for producing the film according to claim 1, wherein an ultraviolet ray blocking layer having an adhesive property is formed on a surface of the concave-convex microstructure body that has a concave-convex microstructure formed of a cured product of an active energy ray curable resin composition on a surface, the surface being on the reverse side of the concave-convex microstructure-side surface.

11. The method for producing a film according to claim 9 or 10, wherein a protective layer is formed on the concave-convex microstructure-side surface of the concave-convex microstructure body.

12. A plate-like product provided with the film according to claim 1.

13. An image display device provided with the film according to claim 1.

14. A solar cell provided with the film according to claim 1.
